# EUROPÄISCHE PATENTANMELDUNG

(11) **EP 0 906 004 A2**
(43) Veröffentlichungstag der Anmeldung: **31.03.1999**
(21) Anmeldenummer: 98115620.1
(22) Anmeldetag: 19.08.1998
(51) Int. Cl.: H05K 1/16

(54) **Mehrlagige Leiterplatte**

(30) Priorität: 30.09.1997 DE 19743242
(71) Anmelder: SIEMENS AKTIENGESELLSCHAFT, 80333 München (DE)
(72) Erfinder: Krug, Wilfried, 58452 Witten (DE)

(57) **Zusammenfassung**

Die Zwischenschicht zwischen den Innenlagen (10,11) wird aus mehreren, jeweils durch dielektrische Schichten (3) getrennte elektrisch leitfähigen Schichten (2) gebildet. Diese leitfähigen Schichten sind abwechselnd mit der einen (10) bzw. mit der anderen (11) leitenden Innenlage, die zur Spannungsversorgung der auf der Leiterplatte vorhandenen Einheiten dient, leitend verbunden. Anstelle einer einfachen Schicht als Dielektrikum zwischen den Innenlagen wird diese Zwischenschicht in der Art eines Kondensators aus mehreren Schichten aufgebaut. Die verwendeten Materialien werden derart zu einer kapazitiven Schicht verarbeitet, daß sich bei Verbindung mit den metallischen Flächen der Innenlagen durch den kondensatorartigen Aufbau für die Zwischenschicht eine wesentlich erhöhte Kapazität ergibt. Dies bewirkt eine niedrigere Impedanz im Frequenzbereich bis 1GHz zwischen den betroffenen Innenlagen der Leiterplatte und damit erhöhte Bedämpfung der Störquellen. Um diesen Effekt des flächendeckend über die Leiterplatte ausgedehnten "Kondensators" zu optimieren, werden die Stellen, an denen eine Kontaktierung aller geradzahligen metallischen Schichten einerseits und aller ungeradzahligen metallischen Schichten andererseits erfolgt, über die Leiterplatte vorzugsweise in einem engeren Raster verteilt. Durch die Verwendung mehrschichtig verbundener Folien, die aus einer metallischen und einer damit verbundenen dielektrischen Schicht bestehen, ergibt sich eine hochkapazitive Zwischenschicht zwischen einem jeden Innenlagenpaar einer Leiterplatte.

## Beschreibung

Die Erfindung betrifft eine mehrlagige Leiterplatte, die leitende Innenlagen aufweist, die durch eine als Dielektrikum wirkende Zwischenschicht elektrisch voneinander getrennt sind.

Eine solche Leiterplatte weist entsprechend dem gewählten Leiterplatten-Layout die darauf vorzusehenden Leiterbahnen und die notwendigen Lötstellen auf. Diese Leiterplatten werden als Montagemittel für bestimmte Bauteile, insbesondere elektronische Baugruppen verwendet. Eine derart bestückte Leiterplatte wird z. B. als elektrische Baugruppe ggf. zusammen mit weiteren Baugruppen in eine konstruktiv entsprechend angepaßte Aufnahmeeinheit eingebracht bzw. sie wird auf eine Grundplatte aufgesteckt. Solche bestückten Leiterplatten sind beispielsweise Teileinheiten eines Kommunikationssystems. Die auf den Leiterplatten montierten elektronischen Baugruppen, wie z. B. integrierte Schaltkreise und die zur Bestückung verwendeten elektronischen Bauteile tauschen untereinander über die Leiterbahnen elektrische Signale aus. Dabei treten neben den Nutzsignalen auch Störsignale auf. Diese Störsignale bzw. die elektromagnetische Störstrahlung, die bei der Kommunikation der elektronischen Baugruppen bzw. Bauteile im jeweiligen System entsteht, kann an seinen Außenschnittstellen nur durch aufwendige besondere Maßnahmen zurückgehalten werden. Insbesondere bei Überleitungen von vernetzten Systemen, werden besondere diskrete Bauteile, wie Entstörfilter bzw. Drosseln hierzu eingesetzt und es werden bestimmte Maßnahmen zur Abschirmung getroffen. Elektronische Baueinheiten, wie z. B. Prozessoren, Speicherbausteine, Treiber und Taktgeneratoren arbeiten mit hohen Taktfrequenzen, die im allgemeinen bei Neuentwicklungen weiter gesteigert werden. Sie verursachen eine über das erlaubte Maß hinausgehende große Störstrahlung, wenn man sie auf derselben Leiterplatte einsetzt.

Eine besondere Methode zur Reduzierung der Störstrahlung besteht darin, diskrete Bauteile, wie Kondensatoren und Widerstände einzusetzen. Diese ermöglichen sinnvolle Entstörmaßnahmen durch eine optimale Plazierung der Blockkondensatoren an den Störquellen. Dies ist mit zusätzlichen Kosten verbunden und es muß aus bestückungstechnischen Gründen ein bestimmter Abstand von diesen diskreten Bauteilen von der Störquelle eingehalten werden. Dies bedingt Wege für die bei den Schaltfunktionen der elektronischen Bauteile gezogenen Ströme, die eine bestimmte Störstrahlung weiterhin zur Folge haben.

Es sind Leiterplatten bekannt, die insbesondere im Hinblick auf die Bestückung mit elektronischen Bauteilen die hohe Taktraten erfordern, als sogenannte Mehrlagenleiterplatten ausgebildet sind. Es weist z. B. eine 4-Lagen-Leiterplatte zwei sogenannte Innenlagen auf, die für die Spannungsversorgung der elektronischen Bauteile herangezogen werden. Diese Innenlagen, die durch eine aus einheitlichen Material bestehendes Dielektrikum getrennt sind, haben eine gewisse Kondensatorwirkung zur Folge. Eine Erhöhung dieser Kondensatorwirkung könnte dadurch erreicht werden, daß die Dicke dieses Dielektrikums weiter verringert wird. Es kann jedoch aus herstellungstechnischen Gründen eine bestimmte Minimaldicke dieses eingebrachten Dielektrikums nicht unterschritten werden. Im Gegensatz zu der Anwendung von diskreten Kondensatoren ist bei der nicht über einen bestimmten Kapazitätswert zu steigernden Kondensatorwirkung dieser genannten Innenlagen die Kapazität räumlich verteilt. Dadurch sind gewisse Anteile näher an den Störquellen. Die Ausnützung dieser Kondensatorwirkung zur Reduzierung der Störstrahlung ist unempfindlicher gegen Änderungen im Störspektrum der Bauteile, als es eine optimale Auswahl diskreter Blockkondensatoren ermöglicht.

Es ist die Aufgabe der Erfindung, die Situation für mehrlagige Leiterplatten bezüglich der Entstehung von Störstrahlungen beim bestimmungsgemäßen Einsatz einer solchen Leiterplatte zu verbessern.

Dies wird dadurch erreicht, daß die zwischen den Innenlagen vorhandene Zwischenschicht aus mehreren, jeweils durch eine dielektische Schicht getrennte elektrisch leitfähigen Schichten besteht und daß diese leitfähigen Schichten abwechselnd mit der die Zwischenschicht jeweils begrenzenden einen bzw. der anderen leitenden Innenlage elektrisch leitend verbunden sind. Anstelle einer einheitlich aufgebauten einfachen Schicht aus Dielektrikum zwischen den Innenlagen einer Mehrlagenleiterplatte entsteht durch das erfindungsgemäß eingesetzte Mehrschichtdielektrikum mit kondensatorartigen Aufbau eine hochkapazitive Wirkung. Dies wird im wesentlichen durch die bei diesem mehrschichtigen Aufbau erhaltene vergrößerte Gesamtfläche erreicht. Um diese Kondensatorstruktur zu erhalten, sind die leitfähigen Schichten abwechselnd mit der einen Innenlage und mit der anderen Innenlage leitend verbunden. Eine solcher flächig ausgedehnter Kondensator, der durch die entsprechende Verarbeitung der verwendeten Schichtmaterialien die isolierende kapaztitve Zwischenschicht bildet, kann erheblich mehr Energie pro Flächeneinheit speichern, als ein heute herstellbares einfaches Dielektrikum, das sich zwischen den für die Spannungsversorgung vorhandenen Innenlagen befindet. Bei gleicher Dicke und Güte des Dielektrikums erhält man bereits einen etwa um die Anzahl der übereinander angebrachten Folien erhöhten Kapazitätswert. Daraus ergibt sich eine niedrigere Impedanz im Frequenzbereich bis 1GHz zwischen den betroffenen Innenlagen der Leiterplatte und damit eine bessere Bedämpfung der Störquellen, als dies bei heuten Mehrlagenleiterplatten der Fall ist. Durch den Einsatz eines solchen Mehrschichtdielektrikums ist zumindest ein großer Teil von diskreten Entstörmaßnahmen auf einer bestimmten Leiterplatte nicht mehr erforderlich. Es reduziert sich auch der Betreuungsaufwand von bestehenden Produkten beim unvermeidlichen Einsatz neuerer, aber in stärkerem Maße eine Störstrahlung ergebender Bauelementeversionen. Die abwechselnd leitfähige Verbindung erfolgt vermittels einer durchgehenden Kontaktierung aller -bezogen auf ein und dieselbe Innenlage- ungeradzahligen metallischen Schichten und davon örtlich getrennt durch eine durchgehende Kontaktierung aller geradzahligen metallischen Schichten. Am Ort einer solchen durchgehenden Kontaktierung ist die jeweils nicht betroffene metallische Schicht gegenüber dieser durchgehenden Kontaktierung elektrisch isoliert. Eine dieser durchgehenden Kontaktierungen ist mit der einen Innenlage und die andere durchgehende Kontaktierung mit der anderen Innenlage elektrisch leitend verbunden.

Die jeweilige elektrische Isolierung erfolgt erfindungsgemäß durch eine geeignete Aussparung in der jeweils nicht betroffenen Schicht. Durch diese Aussparungen können in bestimmter Weise die zusammengehörenden metallischen Schichten zu einem großflächigen Kondensator verbunden werden. Diese so entstehende Zwischenschicht dient dann als Basismaterial zur Herstellung einer Leiterplatte.

Die elektrisch leitenden Verbindungen der elektrisch leitenden Schichten, der sich zwischen den Innenlagen einer Leiterplatte befindlichen Zwischenschicht besteht an mehreren über die Zwischenschichtfläche verteilten Stellen. Die Stellen, an denen eine Kontaktierung der geradzahligen bzw. der ungeradzahligen metallischen Schichten untereinander vorgenommen wird, sind in einem engeren Raster über die Zwischenschicht verteilt. Dadurch wird vermieden, daß für Umladeströme große Wege vorhanden sind. Damit bleibt auch für die störaktiven Frequenzen der Kondensatoreffekt erhalten, da die Induktivität des Strompfades sich nicht negativ auswirken kann.

In besonders einfacher Weise können als dielektrische und als leitfähige Schichten die für die Herstellung von Kondensatoren eingesetzten Folienmaterialien verwendet werden. An diesem Folienmaterial werden die erforderlichen Aussparungen angebracht. Diese Aussparungen können bei einer bestimmten Herstellungsart der durchgehenden Kontaktierungen in der metallischen und der dielektrischen Schicht und nur in der dialektischen Schicht vorhanden sein. Sie werden dann erfindungsgemäß derart in Schichten übereinander gelegt, daß die beiden Arten von Aussparungen abwechseln fluchtend übereinander liegen, so daß bei der Bildung der kompakten Zwischenschicht eine Kontaktierung aller geradzahligen metallischen Schichten einerseits und aller ungeradzahligen metallischen Schichten andererseits erreicht wird. Diese Kontaktierung kann auch dadurch erreicht werden, daß Aussparungen eines ersten Durchmessers in der metallischen und dialektischen Schicht und Aussparungen eines dem gegenüber kleineren Durchmessers in der metallischen und dialektischen Schicht vorgenommen werden. Derartige Aussparungen können beispielsweise durch Bohr- bzw. Stanzvorgänge vorgenommen werden. Die jeweils vorhandenen Aussparungen sind derart bemessen, daß bei dem zu der kompakten mehrschichtigen Zwischenschicht führenden Verarbeitungsschritt eine zusätzliche Kontaktierung mit der jeweils nicht betroffenen metallischen Schicht ausgeschlossen ist. Es wird nur sichergestellt, daß lediglich jede zweite metallische Schicht von oben und jede zweite metallischen Schicht von unten miteinander und der jeweils zugehörigen Innenlage verbunden wird. Im erstgenannten Fall kann erfindungsgemäß die durchgehende Kontaktierung beispielsweise durch Verschweißen der zusammengehörenden metallischen Flächen erfolgen. Im letztgenannten Fall kann der Verarbeitungsschritt zur Bildung der Zwischenschicht darin bestehen, daß die abwechseln fluchtend übereinander liegenden Aussparungen kleineren Durchmessers zwischen denen dann Folien mit Aussparung größeren Durchmessers liegen, zur Einführung eines die elektrische Kontaktierung ermöglichenden Mittels dienen. Durch dieses Mittel erfolgt dann z. B. im Zusammenhang mit einer entsprechenden Wärmeeinwirkung die Verbindung der in der geschilderten Weise zusammengehörenden metallischen Flächen untereinander. Für die in einer Leiterplatte zur Verbindung der verschiedenen Lagen dienenden Durchkontaktierungen muß sichergestellt sein, daß die Zwischenschicht von der Durchkontaktierung durch eine isolierende Schicht getrennt ist.

Durch den Einsatz einer erfindungsgemäß aufgebauten Leiterplatte können die wachsenden Anforderungen an die Eliminierung und Vermeidung von elektromagnetischen Störquellen erfüllt werden. Dabei wird der Design- und Herstellungsprozeß solcher elektronischer Baugruppen bei Verwendung der erfindungsgemäß ausgebildeten hochkapazitiven Zwischenschicht zwischen den Innenlagen nur in einem sehr kleinen Bereich, nämlich dem inneren Ausbau der Leiterplatte geändert. Durch den Wegfall von zusätzlichen Entstörmaßnahmen ergibt sich eine einfacherere Realisierung der Baugruppen-Layouts.

Ausführungsbeispiele der Erfindung werden anhand der Figuren 1 bis 3 erläutert. Es zeigt
- FIG 1a: einen Querschnitt und
- FIG 1b: die Daraufsicht auf ein zu verwendendes Folienmaterial.
- FIG 2: eine Prinzipkonfiguration einer mehrlagigen Leiterplatte mit hochkapazitiver Zwischenschicht und
- FIG 3: eine andere Prinzipkonfiguration der hochkapazitiven Zwischenschicht.

Die Ausführungsbeispiele nach den Figuren sind in dieser schematischen Darstellung in einem vergrößerten Maßstab dargestellt. Es soll damit nur das Prinzip verdeutlicht werden, nach dem der kondensatorartige Aufbau der Zwischenschicht und die notwendige Behandlung der Kontaktierungen erfolgen kann.

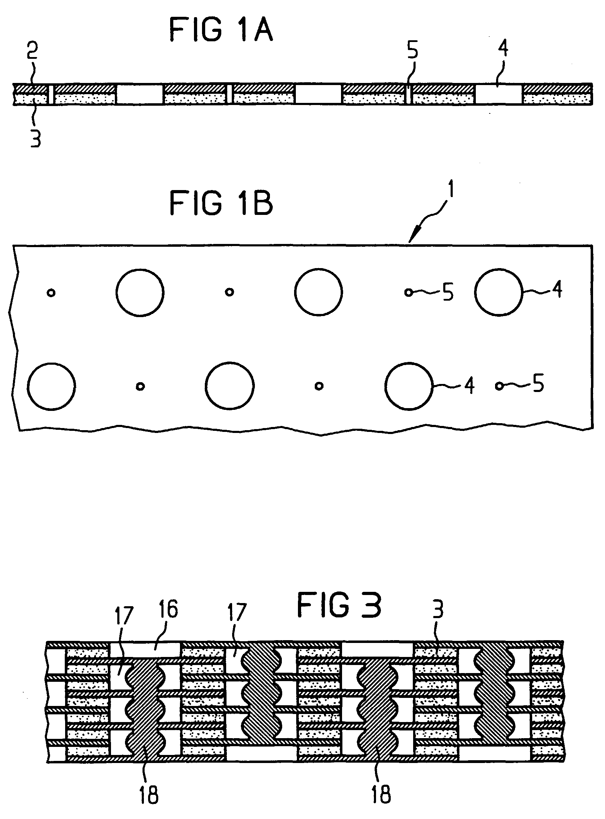

Es können grundsätzlich die zur Herstellung von Kondensatoren vorhandenen Materialien eingesetzt werden. Die FIG 1a zeigt den Querschnitt einer derartigen Folie 1, die aus einer dielektrischen Schicht 3 und einer metallischen Schicht 2 besteht. Sie stellt also prinzipiell z. B. eine einseitig metallisiertes Dielektrikum dar. Um die notwendigen Kontaktierungen bestimmter Metallschichten untereinander vornehmen zu können, weist eine derartige Folie 1 im Raster abwechselnd große und kleine Aussparungen 4 bzw. 5 auf. Diese Aussparungen sind beispielsweise als Stanzlöcher zu realisieren. Die großen Stanzlöcher 4 können beispielsweise einen Durchmesser von ca. 4 mm aufweisen und ihr Rasterabstand kann zwischen 1 und 2 cm betragen. Aus derartig bearbeiteten Folien wird die Zwischenschicht 14 für eine Leiterplatte 15 hergestellt. Diese Leiterplatte ist demnach mehrlagig. Im Beispiel ist eine 4-lagige Leiterplatte darstellt. Als Lagen werden die metallischen Schichten 9 bis 12 bezeichnet. Eine derartige Leiterplatte wird aus jeweils 2-lagigen Leiterplatten, die also aus den metallischen Schichten 9 und 10 und dem dazwischenliegenden Leiterplattensubstrat 13 bzw. aus den metallischen Schichten 11 und 12 und dem dazwischenliegenden Leiterplattensubstrat 14 bestehen hergestellt. Nach dem Zusammenfügen der Leiterplatte 15 aus den jeweils 2-lagigen Leiterplatten unter Verwendung der Zwischenschicht 14 werden die Lagen 10 bzw. 11 zu den genannten Innenlagen, über die die Spannungsversorgung für die Bestückungselemente einer solchen Leiterplatte erfolgt. Die Innenlage 10, die auch in bestimmter Weise strukturiert sein kann, dient z.B. der Zuführung des Spannungspotentiales, während die Innenlage 11 der Zuführung des "Massepotentiales" dient. Das Folienmaterial wird derart zu einer kapazitiven Zwischenschicht 14 verarbeitet, daß sie - mit den metallischen Flächen der Innenlagen 10 bzw. 11 verbunden- einen flächig ausgedehnten "Kondensator" darstellt. Die Bildung der Zwischenschicht 14 erfolgt in der Weise, daß eine Mehrzahl gemäß FIG 1b ausgebildeter Folien versetzt übereinander gelegt werden, so daß kleine (5) und große (4) Löcher -die beispielsweise durch einen Stanzvorgang erzeugt werden- immer abwechselnd aufeinanderfolgen. Dieses Paket kann oben und unten mit je einer nur mit kleinen Löchern versehenen Isolierfolie 7 bzw. 8 abgedeckt sein. Die Verbindung der geradzahligen bzw. der ungeradzahligen metallischen Schichten kann beispielsweise durch punktförmiges Verlöten der Folien an den kleinen Löchern vorgenommen werden. Es erfolgt dann jeweils eine durchgehende Kontaktierung 6, wobei diese Kontaktierung durch die gezeigte "Perlenreihe" symbolisch dargestellt ist. Es werden demnach die metallischen Schichten der einzelnen Folien jeweils an den kleinen "Stanzlöchern" zusammengelötet. Vor diesem in bestimmter Weise zu vollziehenden Lötvorgang kann auf die kleinen Stanzlöcher ein die Löt- und Kontaktfähigkeit steigerndes Mittel, z. B. die sogenannte Reflow-Lotpaste aufgetragen werden. Die Punktlötung kann beispielsweise mit Hilfe eines Laserstrahles durchgeführt werden. Durch das größere Stanzloch wird verhindert, daß die Kontaktierung zur jeweils nicht betroffenen metallischen Schicht hin erfolgt. Die Zwischenschicht 14 ist eine eigenständige Einheit aus der zur Sicherstellung der Kontaktierung sowohl nach oben als auch unten metallische Kontaktpunkte aus der Oberfläche herausragen. Diese dienen dann bei der Herstellung der Leiterplatte 15 als Kontaktierungspunkte zu den Innenlagen 10 bzw. 11. In einer Folge von Kontaktierungspunkten ist also jede zweite durchgehende Kontaktierung 6 gegen die Innenlage 10 bzw. 11 isoliert. In der Leiterplatte könnten durch die erfindungsgemäß gebildete Zwischenschicht 14 auch nur bestimmte Bereiche besetzt sein.

Es liegen zur Bildung der Zwischenschicht also die Aussparungen aller geradzahligen und diejenigen aller ungeradzahligen Folien fluchtend übereinander, so daß zur Anwendung einer geeigneten Verbindungstechnik eine Kontaktierung aller geradzahligen metallischen Schichten einerseits und aller ungeradzahligen metallischen Schichten andererseits erreicht wird. Bei der Herstellung der Leiterplatte 15 mit der erfindungsgemäßen Zwischenschicht 14 sind die geradzahligen metallischen Schichten mit der einen Innenlage 10 und die ungeradzahlig metallischen Schichten mit der anderen Innenlage 11 elektrisch leitend verbunden. Die Festlegung der geradzahligen bzw. ungeradzahligen metallischen Schichten wird dabei ausgehend von ein- und derselben Innenlage, z. B. der Innenlage 10 in Richtung zu anderen Innenlage vorgenommen.

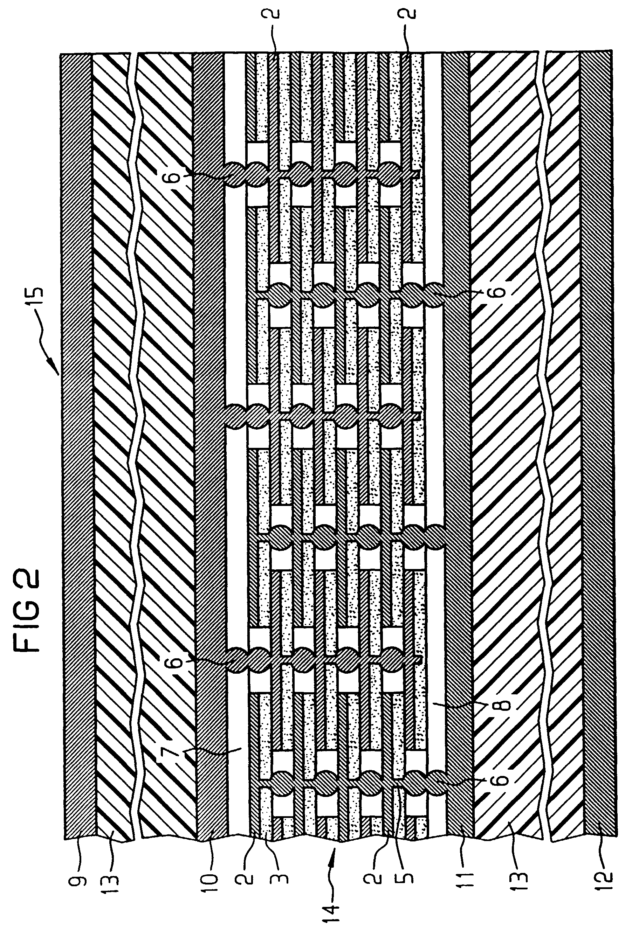

In der FIG 2 ist eine Leiterplatte mit einer einzigen Zwischenschicht 14 dargestellt. Es ist jedoch auch möglich, eine solche Leiterplatte höherlagig auszubilden. Zwischen weiteren Innenlagen kann dann jeweils eine solche Zwischenschicht 14 in gleicher Weise ausgebildet und eingebracht sein. Bei einer z. B. 6-lagigen Leiterplatte würde dann zwischen den beiden zusätzlichen Innenlagen ebenfalls die hochkapazitive Zwischenschicht vorgesehen sein.

In der FIG 3 ist ausschnittsweise eine hochkapazitive Zwischenschicht gezeigt, bei der zur abwechselnden Verbindung der metallischen Folien untereinander diese Folien eine andere Vorverarbeitung aufweisen. Einer die metallische Schicht und die dielektrische Schicht betreffenden Aussparung 16, -z. B. in Form eines entsprechenden Stanzloches realisiert- folgt in einem vorgegebenen Raster jeweils eine Aussparung 17, von der nur die dielektrische Schicht betroffen ist. Diese vorverarbeiteten Folien werden zur Bildung der Zwischenschicht versetzt fluchtend übereinander gelegt. Einer lochförmigen Aussparung 16 steht jeweils flächenmäßig ungefähr gleichen Aussparung 17 gegenüber, die jedoch nur das Dielektrikum betrifft. Von oben beginnend ist dann jede ungeradzahlige Schicht und jede geradzahlige Schicht miteinander verbindbar, da jeweils sich nur die betreffenden metallischen Flächenausschnitte gegenüberstehen. Die eigentliche Verbindung, die durch die "Perlenreihe" 18 symbolisch angedeutet ist, kann dann durch einen Schweißvorgang erfolgen. Die Entfernung der dielektrischen Schicht kann z. B. durch Verwendung eines diese Schicht im Bereich der gewünschten Aussparung auflösenden Mittels vorgenommen werden. Eine Entfernung dieser Schicht könnte auch durch eine Lasereinwirkung erfolgen.

## Patentansprüche

1. Mehrlagige Leiterplatte (15), die leitende Innenlagen (10, 11) aufweist, die durch eine als Dielektrikum wirkende Zwischenschicht elektrisch getrennt sind,
**dadurch gekennzeichnet,**
daß die jeweilige Zwischenschicht (14) aus mehreren jeweils durch eine dielektrische Schicht (3) getrennte leitfähige Schichten (2) besteht und daß diese leitfähigen Schichten abwechselnd mit der die Zwischenschicht begrenzenden einen leitenden Innenlage (10) bzw. mit der anderen leitenden Innenlage (11) elektrisch leitend verbunden sind.

2. Mehrlagige Leiterplatte nach Anspruch 1,
**dadurch gekennzeichnet,**
daß die abwechselnde Verbindung vermittels einer durchgehenden Kontaktierung aller -bezüglich ein- und derselben Innenlage (10)- ungeradzahligen metallischen Schichten und davon örtlich getrennt durch eine durchgehende Kontaktierung aller diesbezüglich geradzahligen metallischen Schichten erfolgt und daß am Ort einer durchgehenden Kontaktierung jeweils nicht betroffene metallische Schichten gegenüber dieser jeweiligen Kontaktierung elektrisch isoliert sind und die durchgehende Kontaktierung mit der einen Innenlage (10) und bzw. mit der anderen Innenlage (11) elektrisch leitend verbunden ist.

3. Mehrlagige Leiterplatte nach Anspruch 2,
**dadurch gekennzeichnet,**
daß die jeweilige elektrische Isolierung durch eine geeignete Aussparung (4) bzw. (16) in der jeweils nicht betroffenen Schicht erfolgt.

4. Mehrlagige Leiterplatte nach einem der vorhergehenden Ansprüche,
**dadurch gekennzeichnet,**
daß die elektrisch leitenden Verbindungen der elektrisch leitenden Schichten der Zwischenschicht 14 an mehreren über die Zwischenschichtfläche verteilten Stellen bestehen.

5. Mehrlagige Leiterplatte nach Anspruch 4,
**dadurch gekennzeichnet,**
daß die Stellen, an denen eine Kontaktierung der bezüglich ein- und derselben Innenlage (10) geradzahligen bzw. der ungeradzahligen metallischen Schichten untereinander vorgenommen wird, rasterförmig in einem engeren Raster über die zwischen den Innenlagen angeordnete Zwischenschicht verteilt sind.

6. Mehrlagige Leiterplatte nach einem der vorhergehenden Ansprüche,
**dadurch gekennzeichnet,**
daß als dielektrische und als leitfähige Schichten, die für die Herstellung von Kondensatoren eingesetzten Folienmaterialen verwendet sind.

7. Mehrlagige Leiterplatte nach Anspruch 5 oder 6,
**dadurch gekennzeichnet,**
daß das Folienmaterial mit Aussparungen in der metallischen und der dielektrischen Schicht (16) und mit Aussparungen nur in der dielektrischen Schicht (17) versehen und derart in Schichten übereinander gelegt ist, daß die beiden Arten von Aussparungen abwechselnd fluchtend übereinander liegen, so daß zur Bildung der kompakten Zwischenschicht (14) eine Kontaktierung aller -bezogen auf ein- und dieselbe Innenlage (10)- geradzahligen metallischen Schichten einerseits und aller ungeradzahligen metallischen Schichten andererseits erreicht wird und daß die miteinander kontaktierten geradzahligen Schichten mit der einen Innenlage (10) und die miteinander kontaktierten ungeradzahligen Schichten mit der anderen Innenlage (11) elektrisch leitend verbunden sind. (FIG 3)

8. Mehrlagige Leiterplatte nach Anspruch 5 oder 6, **dadurch gekennzeichnet,**
daß das Folienmaterial mit Aussparungen (4) eines ersten Durchmessers in der metallischen und dielektrischen Schicht und mit Aussparungen (5) eines demgegenüber kleineren Durchmessers in der metallischen und dielektrischen Schicht versehen und derart in Schichten übereinandergelegt ist, daß die beiden Arten von Aussparungen abwechselnd fluchtend übereinander liegen, so daß bei der Bildung der kompakten Zwischenschicht eine Kontaktierung aller -bezogen auf ein- und dieselbe Innenlage (10)- geradzahligen metallischen Schichten einerseits und aller ungeradzahligen metallischen Schichten andererseits erreicht wird und daß die miteinander kontaktierten geradzahligen Schichten mit der einen Innenlage (10) und die miteinander kontaktierten ungeradzahligen Schichten mit der anderen Innenlage (11) elektrisch leitend verbunden sind. (FIG 2)

9. Mehrlagige Leiterplatte nach Anspruch 7 oder 8,
**dadurch gekennzeichnet,**
daß die zur Kontaktierung aller geradzahligen metallischen Schichten bzw. die zur Kontaktierung aller ungeradzahligen metallischen Schichten in den jeweils benachbarten ungeradzahligen bzw. geradzahligen metallischen Schichten vorhandenen Aussparungen (4, 17) derart groß bemessen sind, daß bei dem zu der Zwischenschicht führenden Verarbeitungsschritt eine zusätzliche Kontaktierung mit dieser unmittelbar benachbarten metallischen Schicht ausgeschlossen ist.

10. Mehrlagige Leiterplatte nach Anspruch 7 und 9,
**dadurch gekennzeichnet,**
daß der Verarbeitungsschritt zur Bildung der Zwischenschicht (14) darin besteht, daß die übereinanderliegenden Schichten derart unmittelbar zusammengepreßt und ggf. thermisch beeinflußt werden, daß die sich dabei im Bereich der Aussparungen (17, 16) berührenden metallischen Schichten im Sinne eines Verschweißens miteinander verbunden sind.

11. Mehrlagige Leiterplatte nach Anspruch 8 und 9,
**dadurch gekennzeichnet,**
daß der Verarbeitungsschritt zur Bildung der Zwischenschicht (14) darin besteht, daß die abwechselnd fluchtend übereinander liegenden Aussparungen kleinerer Durchmesser zur Einführung bzw. Aufnahme eines die elektrische Kontaktierung ermöglichenden Mittels dienen, durch das die Verbindung untereinander vorgenommen wird.

12. Mehrlagige Leiterplatte nach einem der vorhandenen Ansprüche,
**dadurch gekennzeichnet,**
daß für die darin vorhandenen und verschiedene Lagen verbindende Durchkontaktierungen sichergestellt ist, daß die Zwischenschicht (14) gegenüber einer solchen Durchkontaktierung durch eine isolierende Schicht getrennt ist.

13. Mehrlagige Leiterplatte nach einem der vorhergehenden Ansprüche,
**dadurch gekennzeichnet,**
daß sie einen Teil einer elektrischen Funktionseinheit darstellt und u. a. mit Einheiten, integrierten Bausteinen und Elementen bestückt ist, die vorzugsweise hochfrequente elektrische Signale erzeugen und/oder verarbeiten und denen über die Innenlage die Versorgungsspannung zur Verfügung gestellt wird.
